Europäisches Patentamt

(19) European Patent Office

Office européen des brevets

(11) Veröffentlichungsnummer: **0 011 148**
**B1**

(12) **EUROPÄISCHE PATENTSCHRIFT**

(45) Veröffentlichungstag der Patentschrift:
14.10.81

(51) Int. Cl.³: **C 23 C 11/00**, C 23 C 11/08,
A 61 C 1/05

(21) Anmeldenummer: 79104012.4

(22) Anmeldetag: 17.10.79

(54) CVD-Beschichtungsvorrichtung für Kleinteile und ihre Verwendung zur Beschichtung von Spannelementen von Dentalturbinen.

(30) Priorität: 13.11.78 DE 2849240

(43) Veröffentlichungstag der Anmeldung:
28.05.80 Patentblatt 80/11

(45) Bekanntmachung des Hinweises auf die Patenterteilung:
14.10.81 Patentblatt 81/41

(84) Benannte Vertragsstaaten:
AT CH FR SE

(56) Entgegenhaltungen:
AT-B-288 811
DE-A1-2 218 609
DE-A1-2 539 434
GB-A-1 356 769
US-A-3 796 182

(73) Patentinhaber: SIEMENS AKTIENGESELLSCHAFT Berlin
und München, Postfach 22 02 61, D-8000 München 22 (DE)

(72) Erfinder: Politycki, Alfred, Dr., Zirbelweg 7,
D-8012 Ottobrunn (DE)
Erfinder: Hieber, Konrad, Dr., Aiblinger Strasse 3,
D-8000 München 19 (DE)
Erfinder: Stolz, Manfred, Lorentzstrasse 102,
D-8000 München 83 (DE)

### CVD-Beschichtungsvorrichtung für Kleinteile und ihre Verwendung zur Beschichtung von Spannelementen von Dentalturbinen.

Die vorliegende Patentanmeldung betrifft eine Vorrichtung zum gleichzeitigen Behandeln von Kleinteilen unter Anwendung der CVD-(Chemical-Vapour-Deposition)-Beschichtungstechnik, bestehend aus einem mit einer Gaszuführungs- und Gasableitung versehenen, doppelwandig ausgebildeten Reaktor, einem in diesem angeordneten Suszeptor, der ein Traggestell mit den zu beschichtenden Teilen enthält und durch eine Induktionsspule zum Glühen gebracht wird, und einer zusätzlichen Gaszuleitung zur Zuführung von Spülgas in den Reaktor.

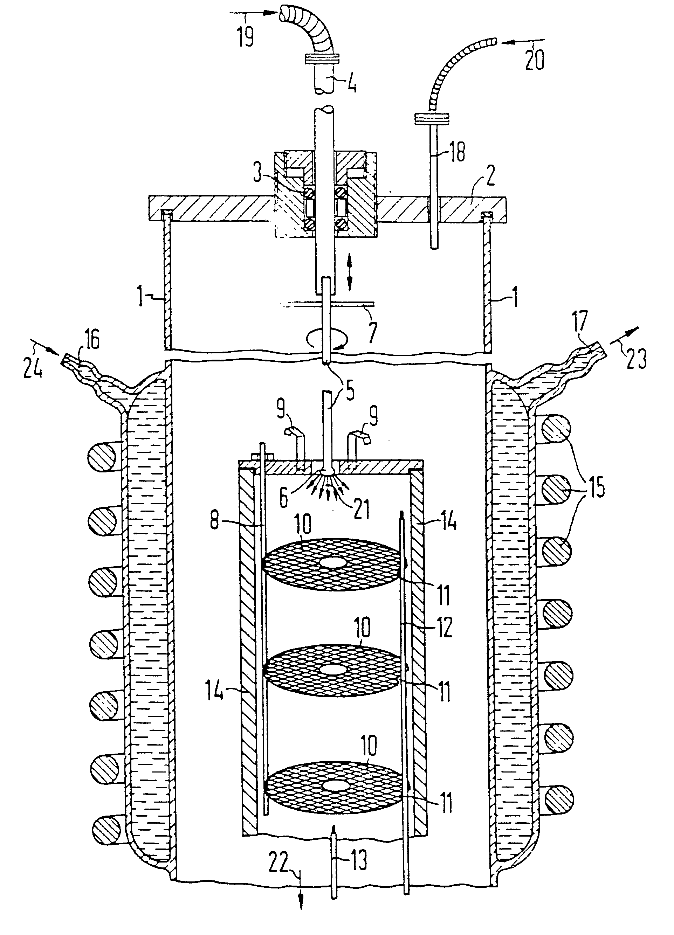

Ähnliche Vorrichtungen sind aus der Zeitschrift »Metalloberfläche« 30 (1976) 10, Seite 474, Bild 1, aus der VDI-Zeitschrift 114 (1972), Seite 1222, Bild 3, sowie aus der DE-OS 25 39 434 bekannt.

Bei der Beschichtung von Werkstücken durch chemische Reaktionen aus der Gasphase, Chemical-Vapour-Deposition = CVD genannt, ist die Reproduzierbarkeit der Ergebnisse hinsichtlich Schichtdicke, Rauhigkeit, Haftung und Härte der aufgebrachten Überzüge trotz vergleichbarer Versuchsbedingungen oft nicht ausreichend. Dabei lassen sich drei störende Einflüsse erkennen:

1. Die Schichten werden im unteren bzw. rückwärtigen Teil des Reaktors dünner.
2. Die Turbulenz im, das Abscheidungsmaterial enthaltenden Gasstrom verursacht lokale Konzentrations- und Temperaturunterschiede.
3. Zwischenprodukte der Gasabscheidung, die sich an der Reaktorwand niederschlagen, beeinflussen den Reaktionsverlauf dadurch, daß sie unkontrollierbare katalytische Effekte hervorrufen oder (bei induktiver Beheizung) Überschläge verursachen.

Aus der DE-A-25 39 434 ist eine Vorrichtung zur Rundumbeschichtung von Kleinteilen bekannt, bei der diese störenden Einflüsse durch Verwendung eines rotierenden Reaktionsgefäßes, welches von einer temperierten Flüssigkeit umspült wird, gemindert werden. Diese Vorrichtung ist für die Beschichtung von kleinen kugelförmigen Teilen (Schüttgut) einsetzbar; bei sperrigen Kleinteilen ist eine gute Durchmischung der Teile nicht möglich.

Die unter Punkt 1 und 2 angegebenen Mängel lassen sich dann nur dadurch verringern, daß der Gasdruck niedriger gehalten wird und/oder der Glühbereich verkürzt wird. Dies hat aber eine wesentliche Ausbeuteverminderung zur Folge. Der unter Punkt 3 angegebene Mangel konnte bis jetzt nicht beseitigt werden.

Ein weiterer Nachteil der bekannten CVD-Anlagen ist dadurch gegeben, daß der in vielen Fällen nach der Beschichtung der Werkstücke durchzuführende Härteprozeß, welcher darin besteht, daß die Teile aus dem Glühzustand mittels eines kalten Gasstromes abgeschreckt werden, in der Beschichtungsanlage nicht optimal durchgeführt werden kann, weil der Abkühlvorgang wegen der Geräteteile mit zu großen Wärmekapazitäten nicht rasch genug erfolgt. Es ist deshalb ein zusätzlicher Arbeitsvorgang außerhalb des Reaktors erforderlich, wobei die Teile erneut geglüht und in herkömmlicher Weise gehärtet werden.

Die Aufgabe, die der Erfindung zugrundeliegt, besteht deshalb in der Schaffung eines CVD-Reaktors, der die geschilderten Nachteile vermeidet und die Möglichkeit bietet, den auf die Beschichtung folgenden Härteprozeß in das Reaktorsystem zu integrieren.

Die Erfindung löst die gestellte Aufgabe durch eine Vorrichtung der eingangs genannten Art, welche dadurch gekennzeichnet ist, daß die von oben in den Reaktor geführte, in der Höhe verstellbare und drehbare Gaszuführungsleitung über eine Aufhängevorrichtung mit dem Traggestell gekoppelt und mit diesem axial verschiebbar ist, im ausgekoppelten Zustand aber relativ zum Traggestell in axialer Richtung bewegbar ausgebildet ist.

In einer Weiterbildung des Erfindungsgedankens ist vorgesehen, die dreh- und verschiebbar ausgebildete Gaszuführungsleitung mit einer Verteilerdüse aus Quarz auszustatten.

Um eine vorzeitige Reaktion der Gase innerhalb der Düse zu vermeiden, hat es sich als vorteilhaft erwiesen, die Gaszuführungsleitung mit einer Kühlung zu versehen. Die Bewegung der Gaszuführungsleitung erfolgt vorzugsweise über ein Motorgetriebe.

Im folgenden soll anhand der Beschreibung der in der Zeichnung befindlichen Figur noch weitere Einzelheiten und Vorteile der erfindungsgemäßen Vorrichtung erläutert werden. Die Figur zeigt im Schnittbild in schematischer Darstellung den oberen Teil einer CVD-Apparatur gemäß der Erfindung.

Der aus Quarz bestehende Reaktor 1 ist an seinem oberen Ende mittels einer Deckplatte 2 aus Stahl verschlossen, durch welche vakuumdicht eine über Simmerringkammern 3 axial verschiebbare Gaszuführungsleitung 4 geführt ist, die an ihrem unteren Ende in ein Gaszuführungsrohr 5 übergeht und in eine aus Quarz bestehende Verteilerdüse 6 mündet. Am oberen Ende des Gaszuführungsrohres 5 befindet eine Aufhängevorrichtung 7 für die an dem die zu beschichtenden Teile tragenden Gestell 8 befestigten Haken 9. Das Tragegestell 8 enthält zur Aufnahme der zu beschichtenden Teile parallel untereinander an diesem angebrachte aus Metallnetzen bestehende tellerartige Böden 10, welche an ihrem äußeren Rand Ausnehmungen 11 für ein Thermoelement 12 enthalten, so daß innerhalb des Reaktionsraumes im Bereich unterhalb der Gasverteilerdüse 6 und im Bereich unterhalb des unteren Bodens 10 durch ein zusätzliches Thermoelement 13 eine genaue Temperaturkontrolle durchgeführt werden kann. Das Tragegestell 8, 10 ist von einem Suszeptor 14 umgeben, welcher über die den Reaktor 1 umgebende Induktionsheizspule 15 erwärmt wird. Im Bereich der Spule 15 ist der Reaktor 1 doppelwandig ausgebildet, so daß über die Stutzen 16 und 17 sowohl ein Kühlmittekreislauf als auch ein Ölthermostat angeschlossen werden kann, was beispielsweise von Vorteil sein kann, wenn sich Kondensate aus dem Reaktionsgas auf der inneren Reaktorwand abscheiden.

Während der Beschichtung wird das Tragegestell 9, 10 von dem Suszeptor 14 umschlossen und auf die Abscheidetemperatur aufgeheizt. Dabei wird das Gaszuführungsrohr 5 mit der Verteilerdüse 6 in eine optimale Stellung zu den beschichtenden Teilen gebracht, was durch Nachschieben bzw. Hin- und Herschieben oder Drehen der Verteilerdüse 6 erfolgen kann. Durch die beiden Thermoelemente 12 und 13 werden lokale Temperaturänderungen sofort angezeigt, wodurch Rückschlüsse auf eine veränderte Gasströmung möglich sind.

Wenn die Beschichtung beendet ist, erfolgt der sogenannte Härteprozeß. Dabei müssen die im Glühzustand befindlichen Teile rasch aus der Ofenzone entfernt und mittels eines kalten Gasstromes abgeschreckt werden. Zu diesem Zweck wird die Gaszuführungsleitung 4 über die Aufhängevorrichtung 7 und die Haken 9 mit dem Tragegestell 8, 10 verbunden und mittels eines von außen zu betätigenden Motorgetriebes (nicht dargestellt) nach oben weggezogen, wobei auch die beschichteten Teile aus dem Bereich des heißen Suszeptors 14 gezogen und dem durch die Gaszuleitung 18 einströmenden kalten Spülgas (z. B. Wasserstoff) ausgesetzt werden. Gleichzeitig wird der Reaktor 1 an den Kühlwasserkreislauf angeschlossen und die Spulenheizung abgeschaltet.

Die in der Figur eingezeichneten Pfeile 19, 20, 21 und 22 markieren die Gasströmung bzw. den Kühlmittel- oder Wärmefluß (23, 24). Der Doppel- und der Drehpfeil sollen die axiale Verschiebung bzw. Drehung der Reaktionsgasführung 4, 5, 6 anzeigen.

Die Apparatur hat sich zur Beschichtung von Spannelementen für Dentalbohrer bzw. -turbinen mit verschleißmindernden Überzügen bewährt. Bei Beschichtung mit Titankarbid und Titannitrid (Schichtdicke ca. 5 μm) ließ sich gegenüber unbeschichteten Vergleichsproben eine Verbesserung der Standzeit (Steckzahl) um den Faktor drei erzielen.

Nach dem CVD-Verfahren lassen sich indessen auch andere Karbide und Nitride, sowie Oxide oder metallische Werkstoffe niederschlagen. Als Beispiel sei erwähnt, daß sich Tantalschichten als ausgezeichneter Korrosionsschutz bewährt haben. Die Schichtdicken liegen in derartigen Anwendungsfällen bei ca. 30 μm.

## Patentansprüche

1. Vorrichtung zum gleichzeitigen Behandeln von Kleinteilen unter Anwendung einer CVD-Beschichtungstechnik, bestehend aus einem mit einer Gaszuführungs- und Gasableitung versehenen, doppelwandig ausgebildeten Reaktor, einem in diesem angeordneten Suszeptor, der ein Traggestell mit den zu beschichtenden Teilen enthält und durch eine Induktionsheizspule zum Glühen gebracht wird, und einer zusätzlichen Gaszuleitung zur Zuführung von Spülgas in den Reaktor, dadurch gekennzeichnet, daß die von oben in den Reaktor (1) geführte, in der Höhe verstellbare und drehbare Gaszuführungsleitung (4) über eine Aufhängevorrichtung (7, 9) mit dem Traggestell (8) gekoppelt und mit diesem axial verschiebbar ist, im ausgekoppelten Zustand aber relativ zum Traggestell (8) in axialer Richtung bewegbar ausgebildet ist.

2. Vorrichtung nach Anspruch 1, dadurch gekennzeichnet, daß die dreh- und verschiebbar ausgebildete Gaszuführungsleitung (4) mit einer Verteilerdüse (6) ausgestattet ist.

3. Vorrichtung nach Anspruch 2, dadurch gekennzeichnet, daß die Verteilerdüse (6) aus Quarz besteht.

4. Vorrichtung nach Anspruch 1 bis 3, dadurch gekennzeichnet, daß für die Bewegung der Gaszuführungsleitung (4) ein Motorgetriebe vorgesehen ist.

5. Vorrichtung nach Anspruch 1 bis 4, dadurch gekennzeichnet, daß das Traggestell (8) für die Aufnahme der zu beschichtenden Teile parallel untereinander angeordnete Auflageböden (10) enthält.

6. Verwendung der Vorrichtung nach mindestens einem der Ansprüche 1 bis 5 zur Beschichtung von Spannelementen für Dentalturbinen.

## Claims

1. Apparatus for the simultaneous treatment of small parts using a CVD-coating technique, which consists of a double-walled reactor which is provided with a gas supply line and a gas discharge line, a receptacle which is arranged in the reactor and which includes a supporting frame with the parts to be coated and which is heated to glowing by an induction heating coil, and an additional gas supply line for supplying flushing gas to the reactor, characterised in that the vertically adjustable and rotatable gas supply line (4) which is inserted into the reactor (1) from above is coupled by suspension means (7, 9) to the supporting frame (8) and is axially movable with the latter and that the gas supply line is designed to be movable in the axial direction relative to the supporting frame (8) in the coupled state.

2. Apparatus as claimed in Claim 1, characterised in that the rotatable and adjustable gas supply line (4) is provided with a distribution nozzle (6).

3. Apparatus as claimed in Claim 2, characterised in that the distribution nozzle (6) consists of quartz.

4. Apparatus as claimed in any of Claims 1 to 3, characterised in that a drive motor is provided for the movement of the gas supply line (4).

5. Apparatus as claimed in any of Claims 1 to 4, characterised in that the supporting frame (8) includes support trays for supporting the parts to be coated, said trays being arranged parallel to and below one another.

6. The use of apparatus as claimed in at least one of Claims 1 to 5 for coating clamping elements for dental turbines.

## Revendications

1. Appareil destiné au traitement simultané de petites pièces par l'utilisation de la technique du dépôt en phase vapeur, constitué d'un réacteur, à parois doubles, muni d'un conduit d'amenée et d'un conduit de sortie pour les gaz, d'un suscepteur qui est placé dans le réacteur, qui contient un cadre porteur et qui est porté au rouge par des bobines de chauffage par induction, et d'un conduit supplémentaire d'amenée de gaz de rinçage dans le réacteur, caractérisé en ce que le conduit (4) d'amenée pour les gaz, qui est réglable en hauteur, qui peut tourner et qui est engagé dans le réacteur (1) par le haut, est accouplé par un dispositif (7, 9) de suspension au cadre porteur (8) et peut se placer axialement avec celuici tout en pouvant, lorsqu'il n'est pas accouplé, se déplacer suivant la direction axiale par rapport au cadre porteur (8).

2. Appareil suivant la revendication 1, caractérisé en ce que le conduit (4) d'amenée pour les gaz, qui peut tourner, et qui peut coulisser, est équipé d'une buse (6) de répartition.

3. Appareil suivant la revendication 2, caractérisé en ce que la buse (6) de répartition est en quartz.

4. Appareil suivant les revendications 1 à 3, caractérisé en ce que pour le mouvement du conduit (4) d'amenée pour des gaz, il est prévu un entraînement à moteur.

5. Appareil suivant les revendications 1 à 4, caractérisé en ce que le cadre porteur (8) de réception des pièces a revêtir comprend des plateaux (10) supports disposés parallèlement les uns aux autres.

6. Utilisation de l'appareil suivant l'une au moins des revendications 1 à 5 pour revêtir des éléments de serrage pour des turbines de dentisterie.